# EUROPEAN PATENT APPLICATION

(11) **EP 4 600 944 A1**
(43) Date of publication of application: **13.08.2025**
(21) Application number: 22961471.4
(22) Date of filing: 07.10.2022
(51) Int. Cl.: G10H 1/32

(54) **KEYBOARD INSTRUMENT AND METHOD FOR FORMING MAGNETIC SHIELD**

(71) Applicant: Roland Corporation, Hamamatsu-shi, Shizuoka 431-1304 (JP)
(72) Inventor: HISAMITSU Hajime, Hamamatsu-shi, Shizuoka 431-1304 (JP); SAKASHITA Toshihiko, Hamamatsu-shi, Shizuoka 431-1304 (JP)
(74) Representative: Becker, Eberhard
(86) International application number: PCT/JP2022/037663
(87) International publication number: WO 2024/075285

(57) **Abstract**

Magnetic shields 82a, 82b are formed from conductor patterns of a substrate 8. Hence, the magnetic shields 82a, 82b can be formed thin. Thus, even when a displacement member 7 (detection part 75) is displaced substantially in parallel with the substrate 8, key pressing information based on the increase/decrease of inductance of a coil 80 can be detected while suppressing interference of the magnetic shields 82a, 82b with the displacement of the displacement member 7. Also, even when the displacement member 7 (detection part 75) is displaced perpendicularly to the substrate 8, the key pressing information based on the increase/decrease of the inductance of the coil 80 can be detected. Thus, the degree of design freedom of a keyboard instrument 1 is increased. Further, constraints can be suppressed from being imposed on the arrangement of the substrate 8 by forming the magnetic shields 82a, 82b to be thin from the conductor patterns. This also increases the degree of design freedom of the keyboard instrument 1.

## Description

### Technical Field

The present invention relates to a keyboard device and a magnetic shield forming method, and particularly relates to a keyboard device and a magnetic shield forming method for improving the flexibility in design.

### Related Art

For example, Patent Literature 1 describes a technique which provides a coil for forming a magnetic field in a magnetic detection circuit 12 (substrate) and displaces a magnet 8 relative to the magnetic detection circuit 12 (coil) when a key 2 is depressed. According to this technique, an electromotive force corresponding to the distance and speed of the magnet 8 with respect to the magnetic detection circuit 12 is generated in the coil, which enables detection of the depth and speed of key depression (hereinafter referred to as "key depression information") from the electromotive force.

In Patent Literature 1, the magnetic detection circuits 12 arranged in the scale direction are each partitioned (surrounded) by a shield frame 14, thereby suppressing interference between the magnetic fields of adjacent coils. By suppressing interference between the magnetic fields in this way, the key depression information of each key 2 can be detected with high accuracy.

### Citation List

### Patent Literature

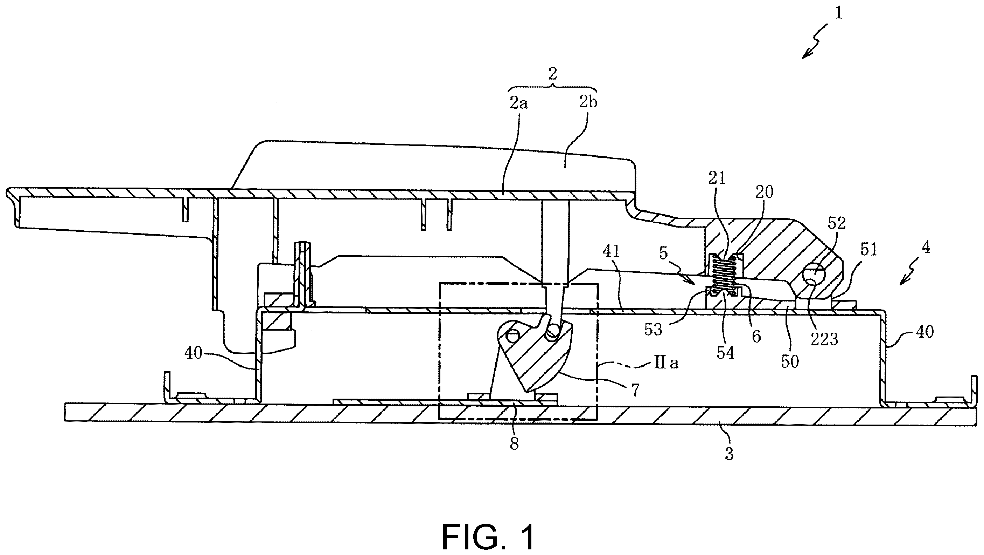

[Patent Literature 1] Japanese Utility Model Application Laid-Open No. 02-111199 (for example, line 3 of page 6 to line 4 of page 7 and lines 2 to 7 of page 9, and FIG. 1)

### SUMMARY OF INVENTION

### Problems to be Solved by the Invention

However, in the conventional technique described above, the shield frame 14 is formed like a wall rising from the magnetic detection circuit 12. Thus, in order to detect the key depression information based on the displacement of the magnet 8, it is necessary to displace the magnet 8 vertically (up and down) with respect to the magnetic detection circuit 12. For example, the magnet 8 cannot be displaced in parallel (in the horizontal direction) to the magnetic detection circuit 12, which tends to restrict the structure of the keyboard device. In addition, it is necessary to secure a space for arranging the shield frame 14 that rises from the magnetic detection circuit 12, which tends to restrict the structure of the keyboard device as well. That is to say, while providing the shield frame 14 can suppress interference between the magnetic fields of adjacent coils, the conventional technique described above has a problem that the flexibility in designing the keyboard device is low.

The present invention has been made in view of the above problems, and the present invention provides a keyboard device and a magnetic shield forming method for improving the flexibility in design.

### Means for Solving the Problems

In order to achieve the above, a keyboard device according to the present invention includes: a plurality of displacement members arranged in a scale direction and displaced according to an operation of a player; and a substrate having a coil which generates a magnetic field for detecting displacement of the plurality of displacement members. The substrate includes a plurality of the coils provided respectively for the plurality of displacement members, and a magnetic shield partitioning the plurality of coils and formed by a conductive pattern of the substrate.

A magnetic shield forming method according to the present invention is provided for forming a magnetic shield in a keyboard device, which includes: a plurality of displacement members arranged in a scale direction and displaced according to an operation of a player, and a substrate having a coil which generates a magnetic field for detecting displacement of the plurality of displacement members. The substrate includes a plurality of the coils provided respectively for the plurality of displacement members, and the magnetic shield partitioning the plurality of coils. The magnetic shield forming method includes: forming the magnetic shield by a conductive pattern of the substrate.

### BRIEF DESCRIPTION OF DRAWINGS

[FIG. 1] is a cross-sectional view of the keyboard device according to the first embodiment.
[FIG. 2] (a) is a partially enlarged cross-sectional view of the keyboard device in the part IIa of FIG. 1, and (b) is a partially enlarged cross-sectional view of the keyboard device along the line IIb-IIb in (a) of FIG. 2.
[FIG. 3] (a) is a partially enlarged cross-sectional view of the substrate in the part IIIa of (b) of FIG. 2, and (b) is a top view of the substrate viewed in the direction of the arrow IIIb in (a) of FIG. 3.
[FIG. 4] (a) is a partially enlarged cross-sectional view of the substrate according to the second embodiment, (b) is a partially enlarged cross-sectional view of the substrate according to the third embodiment, and (c) is a partially enlarged cross-sectional view of the substrate according to the fourth embodiment.
[FIG. 5] (a) is a top view of the substrate according to the fifth embodiment, and (b) is a top view of the substrate according to the sixth embodiment.
[FIG. 6] (a) is a top view of the substrate according to the seventh embodiment, and (b) is a top view of the substrate according to the eighth embodiment.

### DESCRIPTION OF EMBODIMENTS

Preferred embodiments will be described hereinafter with reference to the accompanying drawings. First, the overall configuration of a keyboard device 1 of the first embodiment will be described with reference to FIG. 1. FIG. 1 is a cross-sectional view of the keyboard device 1 of the first embodiment. FIG. 1 shows a cross section cut along a plane that is orthogonal to the scale direction of the keyboard device 1 (direction in which a plurality of keys 2 are arranged). Furthermore, in the following description, the front side as viewed from the player (left side in FIG. 1) is referred to as the front side of the keyboard device 1, the side opposite thereto (right side in FIG. 1) is referred to as the rear side, and the direction in which a plurality of keys 2 are arranged (direction perpendicular to the paper surface of FIG. 1) is referred to as the scale direction.

As shown in FIG. 1, the keyboard device 1 is a keyboard instrument (synthesizer) including a plurality of keys 2. The keys 2 are composed of a plurality of (52 in this embodiment) white keys 2a for playing natural tones and a plurality of (36 in this embodiment) black keys 2b for playing derived tones, and the white keys 2a and black keys 2b are arranged in the scale direction (direction perpendicular to the paper surface of FIG. 1). A total of 88 keys 2 are provided in this embodiment, but the keyboard device may have a configuration of 76 or 61 keys 2.

The keyboard device 1 includes a bottom plate 3 for supporting the white keys 2a and the black keys 2b. The bottom plate 3 is made of synthetic resin, wood, steel plate, or the like and formed in a flat plate shape extending in the scale direction. A chassis 4 is supported on the upper surface of the bottom plate 3.

The chassis 4 includes a pair of legs 40 spaced at a predetermined interval in the front-rear direction (left-right direction in FIG. 1), and a support part 41 connecting the upper ends of the pair of legs 40 in the front-rear direction. The legs 40 and the support part 41 are integrally formed using synthetic resin, wood, steel plate, or the like. A support member 5 for rotatably supporting the key 2 is provided on the upper surface of the rear end side (right side in FIG. 1) of the support part 41.

The structure that supports the white key 2a with the support member 5 and the structure that rotates a displacement member 7 with the white key 2a will be described hereinafter, and substantially the same structures are provided for the black key 2b.

The support member 5 includes an attached portion 50 attached to the upper surface of the chassis 4 (support part 41), a wall portion 51 rising upward from the attached portion 50, and a columnar shaft portion 52 formed on the upper end side of the wall portion 51. These portions 50 to 52 are integrally formed using a resin material (synthetic resin).

Although not shown, the attached portion 50 is formed in a plate shape extending in the scale direction, and a plurality of wall portions 51 are arranged in the scale direction on the attached portion 50. The rear end portion of the white key 2a is rotatably supported by the shaft portion 52 between the opposing surfaces of the wall portions 51.

A cylindrical holding wall 53 for holding a coil spring 6 is formed on the upper surface of the front end side (the end on the left side in FIG. 1) of the attached portion 50, and a plurality of holding walls 53 are arranged in the scale direction. A conical convex portion 54 that protrudes upward is formed in the central portion of the inner peripheral side of each holding wall 53.

A concave portion 20 is formed on the lower surface of the white key 2a at a position facing the holding wall 53 vertically, and a conical convex portion 21 that protrudes downward is formed on the inner peripheral side of the concave portion 20. The coil spring 6 is sandwiched from above and below between the convex portion 54 of the support member 5 and the convex portion 21 of the white key 2a so that the coil spring 6 is held on the inner peripheral sides of the holding wall 53 and the concave portion 20.

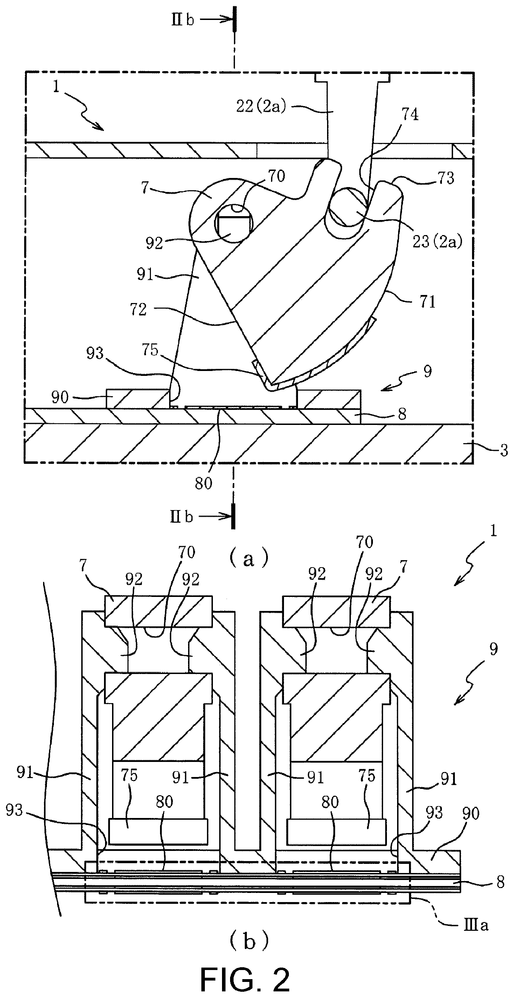

When the white key 2a is depressed, the elastic force of the coil spring 6 gives a feeling of key depression. Besides, when the white key 2a is released after being depressed, the elastic recovery force of the coil spring 6 returns the white key 2a to the initial position. During such key depression and key release, the displacement member 7 is interlocked with the rotation of the white key 2a around the shaft portion 52, and the displacement of the displacement member 7 is detected by a coil 80 (see FIG. 2) of a substrate 8.

The detailed configuration for detecting the displacement of the displacement member 7 will be described with reference to FIG. 2. (a) of FIG. 2 is a partially enlarged cross-sectional view of the keyboard device 1 in the part IIa of FIG. 1, and (b) of FIG. 2 is a partially enlarged cross-sectional view of the keyboard device 1 along the line IIb-IIb in (a) of FIG. 2. In (b) of FIG. 2, illustration of a part of the configuration (white keys 2a, bottom plate 3, etc.) is omitted and only the main parts of the keyboard device 1 are illustrated, and the hatching of the substrate 8 is omitted.

As shown in FIG. 2, a plate-shaped substrate 8 extending in the scale direction (left-right direction in (b) of FIG. 2) is fixed to the bottom plate 3, and a plurality of coils 80 are arranged on the substrate 8 in the scale direction. The coil 80 generates a magnetic field for detecting displacement of the displacement member 7 provided for each of the plurality of keys 2, and details thereof will be described later.

The displacement member 7 is rotatably supported by a holder 9 above each coil 80. The holder 9 includes an attached portion 90 that is attached to the upper surface of the substrate 8, and the attached portion 90 is formed in a plate shape extending in the scale direction.

A plurality of wall portions 91 arranged in the scale direction rises upward from the attached portion 90, and a columnar shaft portion 92 for axially supporting the displacement member 7 is formed on the upper end side of the wall portion 91. The parts 90 to 92 of the holder 9 are integrally formed using a resin material (synthetic resin).

A plurality of through holes 93 arranged in the scale direction are formed in the attached portion 90, and the plurality of through holes 93 are formed at positions corresponding to the respective coils 80. Shaft portions 92 protrude toward each other respectively from a pair of wall portions 91 which face each other across the through hole 93, and an insertion hole 70 for inserting the shaft portion 92 penetrates through the displacement member 7 in the scale direction. Although illustration is omitted, the wall portions 91 (attached portion 90) are elastically deformed to widen the interval between the opposing shaft portions 92, which allows the shaft portions 92 to be inserted into the insertion hole 70 of the displacement member 7. The shaft portions 92 rotatably support the displacement member 7 at a position facing the coil 80 (through hole 93) vertically.

A bottom surface 71 of the displacement member 7 (surface facing the coil 80 when the displacement member 7 is displaced by key depression) is formed in an arc shape centering on the insertion hole 70 (shaft portion 92). A front surface 72 and a rear surface 73 of the displacement member 7 are connected to both ends of the bottom surface 71 in the rotation direction of the displacement member 7 around the shaft portion 92. The front surface 72 of the displacement member 7 faces the front side (lower left side in (a) of FIG. 2) in the same direction and the rear surface 73 of the displacement member 7 faces the rear side (upper right side in (a) of FIG. 2). A groove 74 linearly extends from the rear surface 73 of the displacement member 7 toward the front side (lower left in (a) of FIG. 2) in the displacement direction of the displacement member 7.

A protruding portion 22 protrudes downward from the lower surface of the white key 2a, and a columnar guide pin 23 protrudes from the side surface of the protruding portion 22 in the scale direction. The protruding portion 22 and the guide pin 23 are integrally formed with the white key 2a, but the protruding portion 22 and the guide pin 23 may be formed separately from the white key 2a (the protruding portion 22 is fitted into the white key 2a).

The guide pin 23 is slidably engaged with the groove 74 of the displacement member 7, and the groove 74 extends to intersect the displacement trajectory of the guide pin 23 around the shaft portion 52 (see FIG. 1). Thus, although illustration is omitted, when the guide pin 23 rotates around the shaft portion 52 (see FIG. 1) as the white key 2a is depressed, the groove 74 is pushed by the guide pin 23, causing the displacement member 7 to rotate around the shaft portion 92 (clockwise in (a) of FIG. 2).

Due to the rotation of the displacement member 7, a detected portion 75 provided on the bottom surface 71 and the front surface 72 of the displacement member 7 is displaced relative to the coil 80 of the substrate 8. That is, as the stroke amount of the white key 2a increases from the state before key depression, the amount of penetration of the detected portion 75 into the region (hereinafter referred to as "detection region") facing the coil 80 increases. The penetration amount of the detected portion 75 refers to the size of the area where the detected portion 75 and the coil 80 face each other in the thickness direction of the substrate 8.

On the other hand, when the white key 2a is released, the elastic recovery force of the coil spring 6 (see FIG. 1) causes the guide pin 23 to rotate around the shaft portion 52 (see FIG. 1) so as to return to the initial state. As the guide pin 23 rotates, the groove 74 is pushed up by the guide pin 23, causing the displacement member 7 to rotate around the shaft portion 92 (counterclockwise in (a) of FIG. 2), and the amount of penetration of the detected portion 75 into the detection region decreases.

Since the detected portion 75 is a conductor formed using a conductive material (such as copper), while a current flows through the coil 80 to generate a magnetic field, the inductance of the coil 80 decreases as the amount of penetration of the detected portion 75 into the detection region is increased, and the inductance of the coil 80 increases as the amount of penetration of the detected portion 75 into the detection region is reduced. The key depression information (note information) of each key 2 is detected based on an increase or decrease in the inductance of the coil 80.

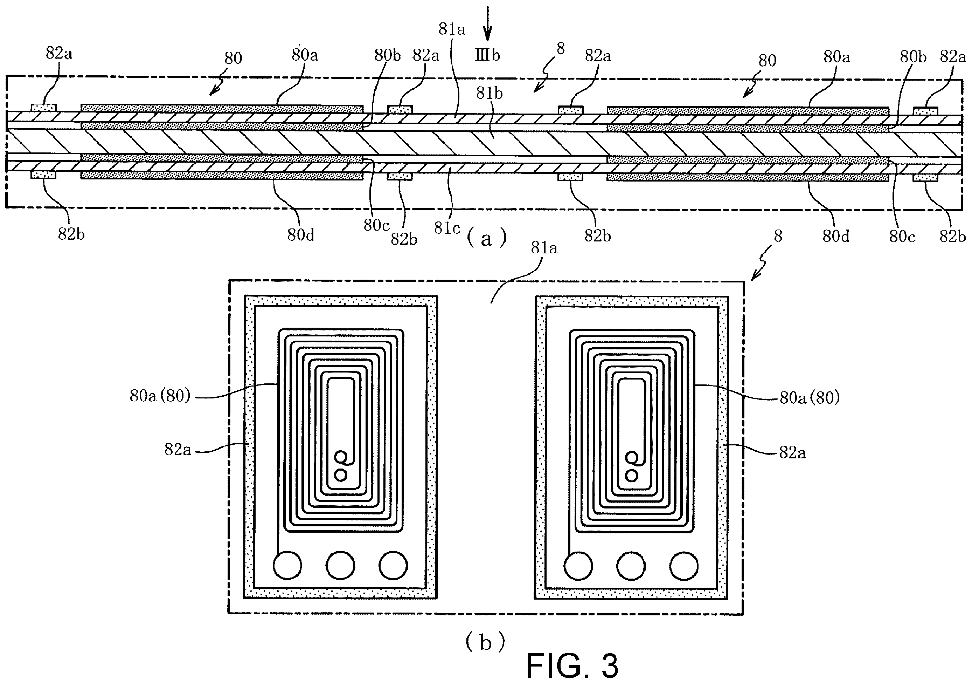

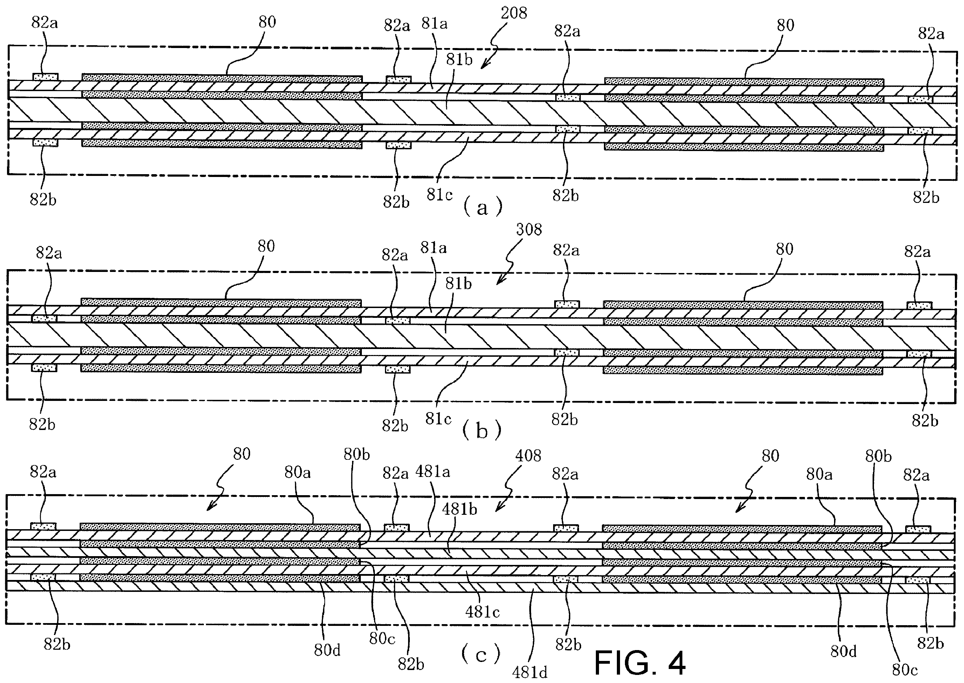

Next, the detailed configuration of the substrate 8 will be described with reference to FIG. 3. (a) of FIG. 3 is a partially enlarged cross-sectional view of the substrate 8 in the part IIIa of (b) of FIG. 2, and (b) of FIG. 3 is a top view of the substrate 8 viewed in the direction of the arrow IIIb in (a) of FIG. 3. In FIG. 3, the resist, etc. covering the coil 80 and the magnetic shields 82a and 82b is omitted, and the cross-sectional structure of the substrate 8 is schematically illustrated. In addition, in (a) of FIG. 3, the cross sections of the coil 80 and the magnetic shields 82a and 82b are hatched with dots, and in (b) of FIG. 3, the region where the magnetic shield 82a is formed when the substrate 8 is viewed from above is hatched with dots. The same applies to the second to eighth embodiments (FIG. 4 to FIG. 6) which will be described later.

As shown in FIG. 3, the substrate 8 is a multilayer substrate (multilayer printed wiring board) in which a plurality of (three in this embodiment) laminated plates 81a to 81c are laminated. Among the laminated plates 81a to 81c, the laminated plates 81a and 81c are laminated on the front and rear of the substrate 8, and the laminated plate 81b is laminated therebetween.

The coil 80 includes a coil 80a laminated on the upper surface (the outer layer on the front surface side of the substrate 8) of the laminated plate 81a, coils 80b and 80c laminated on the inner layers between the laminated plates 81a to 81c, and a coil 80d laminated on the lower surface (the outer layer on the rear surface side of the substrate 8) of the laminated plate 81c. In this embodiment, the coil 80 (coils 80a to 80d) is formed in a rectangular shape in the top view of the substrate 8 (see (b) of FIG. 3), but a circular coil 80 may also be used.

When manufacturing the coils 80a to 80d laminated in this way, first, the coils 80b and 80c are formed by etching the copper foils on both surfaces of the laminated plate 81b (copper-clad laminated plate with both front and rear surfaces covered with copper foils). Next, the coils 80a and 80d are formed by etching the copper foils of the laminated plates 81a and 81c (copper-clad laminated plates with one surface covered with a copper foil), and the laminated plates 81a to 81c are overlapped with the coils 80a and 80d on the front and rear of the substrate 8. Thereby, the substrate 8 in which the coils 80a to 80d (conductor layers) and the laminated plates 81a to 81c (insulating layers) are laminated is manufactured.

That is, each coil 80 on the substrate 8 is formed by a conductor pattern of the substrate 8. In the following description, the formation by etching of the copper foil is simply described as "formed by the conductor pattern of the substrate 8."

The coils 80 formed by such a conductor pattern are arranged in the scale direction (left-right direction in FIG. 3), but each of the coils 80 is partitioned by the magnetic shields 82a and 82b that are conductors, thereby suppressing interference between the magnetic fields of the coils 80 adjacent to each other in the scale direction. By suppressing such magnetic field interference (reducing the mutual inductance between adjacent coils 80), the key depression information of each key 2 can be detected with high accuracy.

Since the magnetic shields 82a and 82b are formed by the conductor pattern of the substrate 8 like the coils 80, the magnetic shields 82a and 82b can be formed thin. Thus, even if the displacement member 7 (detected portion 75) is displaced substantially in parallel to the substrate 8 (see FIG. 2), the key depression information based on an increase or decrease in the inductance of the coil 80 can be detected while suppressing the magnetic shields 82a and 82b from interfering with the displacement of the displacement member 7. Besides, even if a configuration corresponding to the detected portion 75 is provided on the key 2 and the displacement member 7 (detected portion 75) is displaced vertically with respect to the substrate 8, as in the related art (Japanese Utility Model Application Laid-Open No. 02-111199), the key depression information based on an increase or decrease in the inductance of the coil 80 can be detected. Therefore, the flexibility in designing the keyboard device 1 is improved.

Further, forming the magnetic shields 82a and 82b thin with the conductor pattern can reduce restrictions on the arrangement of the substrate 8, which also improves the flexibility in designing the keyboard device 1.

The magnetic shields 82a and 82b are formed in a ring shape (rectangular ring shape) surrounding the entire periphery of the coil 80 when viewed from the top (see (b) of FIG. 3), which can effectively suppress interference between the magnetic fields of adjacent coils 80 and thereby detect the key depression information with high accuracy.

Here, when there is a change in the current flowing through the coil 80, the magnetic field generated from the coil 80 also changes. Due to the change in the magnetic field of the coil 80, an induced current is generated in the conductive magnetic shields 82a and 82b that surround the coil 80. Because the magnetic field of the magnetic shields 82a and 82b generated by this induced current is opposite to the magnetic field of the coil 80, the magnetic field of the coil 80 can be canceled by the magnetic field of the magnetic shields 82a and 82b to suppress interference between the magnetic fields of adjacent coils 80.

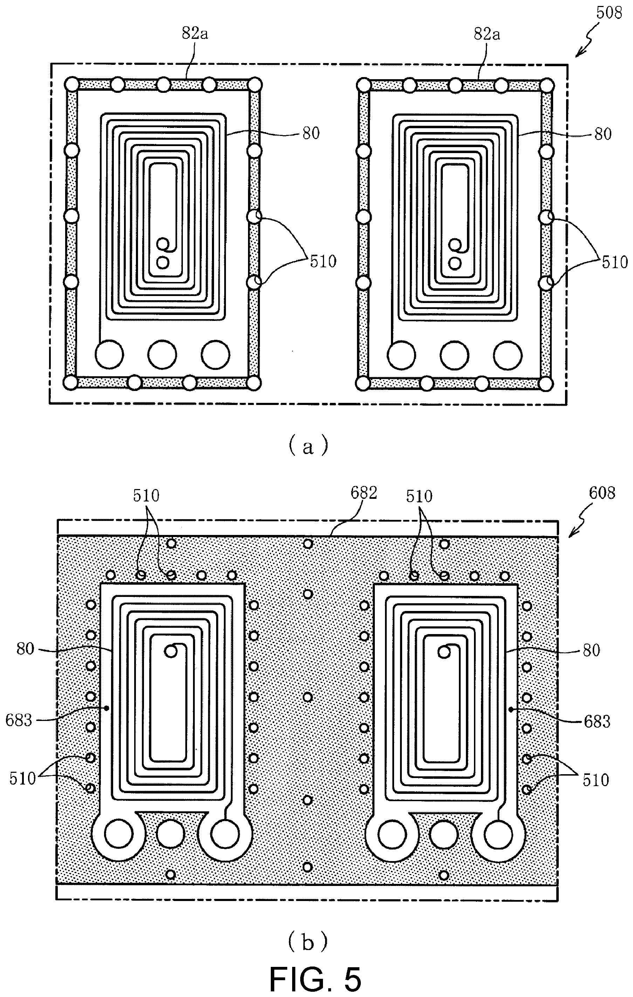

The magnetic field of the magnetic shields 82a and 82b (magnetic field that cancels the magnetic field of the coil 80) is less likely to occur when the magnetic shield 682 is grounded, as in the sixth embodiment (see (b) of FIG. 5) described later, for example. This is because when the magnetic shield 682 is grounded, part of the induced current generated in the magnetic shield 682 flows to the ground (current remaining in the magnetic shield 682 is reduced) and causes the strength of the magnetic field generated in the magnetic shield 682 to decrease.

Moreover, when the magnetic shield 682 is formed in a wide planar shape as in the sixth embodiment, the path of the induced current generated in the magnetic shield 682 is widened. When the path of the induced current is widened, a weak current flows in a wide range in the magnetic shield 682, so the strength of the magnetic field of the magnetic shield 682 decreases.

In other words, in the configuration in which the magnetic shield 682 is grounded or the configuration in which the magnetic shield 682 is formed in a wide planar shape as in the sixth embodiment, the magnetic field of the magnetic shield 682 generated with the induced current, that is, the strength of the magnetic field that cancels the magnetic field of the coil 80, decreases, so the magnetic fields of adjacent coils 80 are likely to interfere with each other. As a result, the accuracy of detecting the key depression information decreases.

In contrast thereto, the magnetic shields 82a and 82b of this embodiment are not connected to the circuit that constitutes the substrate 8 such as the ground, and the magnetic shields 82a and 82b adjacent to each other in the scale direction are not connected to each other, either. That is, the magnetic shields 82a and 82b are electrically floating on the substrate 8. Therefore, unlike the case where the magnetic shields 82a and 82b are grounded as described above, part of the induced current of the magnetic shields 82a and 82b can be suppressed from flowing to the ground. Thus, it is possible to suppress a decrease in the strength of the magnetic field of the magnetic shields 82a and 82b.

In addition, since the magnetic shields 82a and 82b are formed in a linear shape, the path of the induced current generated in the magnetic shields 82a and 82b can be restricted (a strong current can flow in a relatively narrow range), compared to the case where the magnetic shields 82a and 82b are formed in a wide planar shape. Thereby, it is possible to suppress a decrease in the strength of the magnetic field of the magnetic shields 82a and 82b.

That is, when the magnetic shields 82a and 82b are electrically floating and formed in a linear shape as in this embodiment, the magnetic field generated by the magnetic shields 82a and 82b can moderately cancel the magnetic field of the coil 80, thereby suppressing interference between the magnetic fields of adjacent coils 80 and accordingly detect the key depression information with high accuracy. The linear shape means that the width dimension of the magnetic shields 82a and 82b is, for example, 1% or more and 20% or less of the interval between the coils 80 in the scale direction.

Thus, to accurately detect the key depression information, it is important to both strengthen the magnetic field of the coil 80 (increase self-inductance) and suppress interference between the magnetic fields of the coils 80 (reduce mutual inductance). Therefore, in this embodiment, four layers of coils 80a to 80d are laminated on the substrate 8, and two layers of magnetic shields 82a and 82b are laminated on the substrate 8. As a result, the magnetic field can be strengthened by multiple layers of coils 80, and interference between the magnetic fields of the coils 80 can be suppressed by multiple layers of magnetic shields 82a and 82b. Accordingly, the key depression information can be detected with high accuracy.

It is also conceivable to provide the magnetic shields 82a and 82b on all conductor layers of the substrate 8, for example, when laminating a plurality of coils 80a to 80d and magnetic shields 82a and 82b. That is to say, although the magnetic shields 82a and 82b of this embodiment are formed on the upper surface of the laminated plate 81a and the lower surface of the laminated plate 81c, it is also possible to form the magnetic shields 82a and 82b on the inner layers between the laminated plates 81a to 81c.

However, the inventors found that when the magnetic shields 82a and 82b are formed on all the layers of the substrate 8, the accuracy of detecting the key depression information tends to decrease (the mutual inductance of each coil 80 increases). The inventors considered that the induced current also causes magnetic fields in the magnetic shields 82a and 82b, so if the magnetic shields 82a and 82b are formed on too many layers, the magnetic fields of the magnetic shields 82a and 82b are likely to interfere with the magnetic fields of adjacent coils 80.

Thus, this embodiment adopts a configuration in which the magnetic shields 82a and 82b are not laminated on the inner layers between the laminated plates 81a to 81c. That is, the number of laminations (two layers) of the magnetic shields 82a and 82b is made smaller than the number of laminations (four layers) of the coils 80a to 80d. As a result, the key depression information can be detected with high accuracy (the mutual inductance of each coil 80 is reduced). The reason is considered to be that the magnetic fields of the magnetic shields 82a and 82b are less likely to interfere with the magnetic fields of adjacent coils 80 compared to the case where the magnetic shields 82a and 82b are provided on all layers of the substrate 8 as described above.

Thus, it is considered that the detection accuracy of the key depression information is also affected by the magnetic fields generated in the magnetic shields 82a and 82b. In this case, if the magnetic shields 82a (magnetic shields 82b) adjacent to each other in the scale direction are laminated on different layers as in the second embodiment (see (a) of FIG. 4) described later, for example, interference of the magnetic fields from the magnetic shields 82a and 82b may be received differently in each coil 80. Therefore, in each coil 80 arranged in the scale direction, there may be variations in inductance increase or decrease associated with key depression or key release.

In contrast thereto, in this embodiment, the magnetic shields 82a arranged in the scale direction are laminated on the same layer (upper surface of the laminated plate 81a), and the magnetic shields 82b arranged in the scale direction are laminated on the same layer (lower surface of the laminated plate 81c) as well. Accordingly, interference of the magnetic fields from the magnetic shields 82a and 82b is received uniformly in each coil 80 arranged in the scale direction. Thus, variations in inductance increase or decrease associated with key depression or key release in each coil 80 arranged in the scale direction can be suppressed.

Furthermore, it is also possible to arrange a through hole whose wall surface is plated, such as through hole 510, in the regions where the magnetic shields 82a and 82b are formed, as in the fifth embodiment (see (a) of FIG. 5) described later, for example, but even in such a configuration, the detection accuracy of the key depression information may decrease. The reason is considered to be that the through hole 510 distorts the magnetic field generated in the coil 80 (or the magnetic fields generated in the magnetic shields 82a and 82b due to the induced current).

Thus, this embodiment adopts a configuration in which the through hole 510 is not formed in the regions where the magnetic shields 82a and 82b are formed. Not only the through hole 510, other holes (not shown) constituting the substrate 8 are also formed at positions that do not overlap the magnetic shields 82a and 82b. Other holes constituting the substrate 8 include, for example, plain holes (through holes with no plating on the wall surfaces), vias (through holes or holes connecting between layers), access holes (holes (recesses) for exposing lands provided in the inner layer of the substrate 8), component holes (holes for mounting components), reference holes (through holes for positioning the substrate 8), and the like.

As the substrate 8 has no holes (through holes or recesses) that divide the magnetic shields 82a and 82b or partially cut out the magnetic shields 82a and 82b, the magnetic fields of the coils 80a to 80d as described above can be suppressed from distorting, which enables detection of the key depression information with high accuracy.

Next, the second to fourth embodiments will be described with reference to FIG. 4. The same parts as those in the first embodiment mentioned above will be denoted by the same reference numerals and the description thereof is omitted. (a) of FIG. 4 is a partially enlarged cross-sectional view of the substrate 208 according to the second embodiment, (b) of FIG. 4 is a partially enlarged cross-sectional view of the substrate 308 according to the third embodiment, and (c) of FIG. 4 is a partially enlarged cross-sectional view of the substrate 408 according to the fourth embodiment. The magnetic shields 82a and 82b of the second to fourth embodiments have the same configuration as the magnetic shields 82a and 82b of the first embodiment except for the layers laminated.

As shown in (a) of FIG. 4, the first coil 80 (coil 80 on the left side in (a) of FIG. 4) on the substrate 208 of the second embodiment is surrounded by the magnetic shields 82a and 82b laminated on the outer layers of the laminated plates 81a and 81c. However, the adjacent second coil 80 (coil 80 on the right side in (a) of FIG. 4) is surrounded by the magnetic shields 82a and 82b laminated in the inner layers between the laminated plates 81a to 81c. The first and second coils 80 are alternately arranged in the scale direction.

That is, in the substrate 208 of this embodiment, the magnetic shield 82a and the magnetic shield 82b that are adjacent in the scale direction are respectively laminated in different layers. Such magnetic shields 82a and 82b also make it difficult for the magnetic fields of the coils 80 adjacent in the scale direction to interfere with each other.

As shown in (b) of FIG. 4, the first coil 80 (coil 80 on the left side in (b) of FIG. 4) on the substrate 308 of the third embodiment is surrounded by the magnetic shield 82a laminated in the inner layer between the laminated plates 81a and 81b and the magnetic shield 82b laminated on the outer layer of the laminated plate 81c. However, the adjacent second coil 80 (coil 80 on the right side in (b) of FIG. 4) is surrounded by the magnetic shield 82a laminated on the outer layer of the laminated plate 81a and the magnetic shield 82b laminated in the inner layer between the laminated plates 81b and 81c. The first and second coils 80 are alternately arranged in the scale direction.

That is, in the substrate 308 of this embodiment, the magnetic shield 82a and the magnetic shield 82b that are adjacent in the scale direction are respectively laminated in different layers as well. Such magnetic shields 82a and 82b also make it difficult for the magnetic fields of the coils 80 adjacent in the scale direction to interfere with each other.

In addition, a configuration may be made by combining the lamination methods of the second and third embodiments (alternately repeating the lamination method of magnetic shields 82a and 82b shown in (a) of FIG. 4 and the lamination method of magnetic shields 82a and 82b shown in (b) of FIG. 4 in the scale direction).

As shown in (c) of FIG. 4, the substrate 408 of the fourth embodiment is a multilayer substrate in which four laminated plates 481a to 481d are laminated. Each of these laminated plates 481a to 481d is a copper-clad laminated plate whose upper surface (one surface) is covered with copper foil, and the coils 80a to 80d are formed by conductor patterns on the upper surfaces of the laminated plates 481a to 481d.

The magnetic shields 82a are arranged in the scale direction on the upper surface of the laminated plate 481a, and the magnetic shields 82b are arranged in the scale direction in the inner layer between the laminated plates 481c and 481d. That is, each magnetic shield 82a or each magnetic shield 82b arranged in the scale direction is laminated in the same layer. Accordingly, interference of the magnetic fields from the magnetic shields 82a and 82b is received uniformly in each coil 80 arranged in the scale direction.

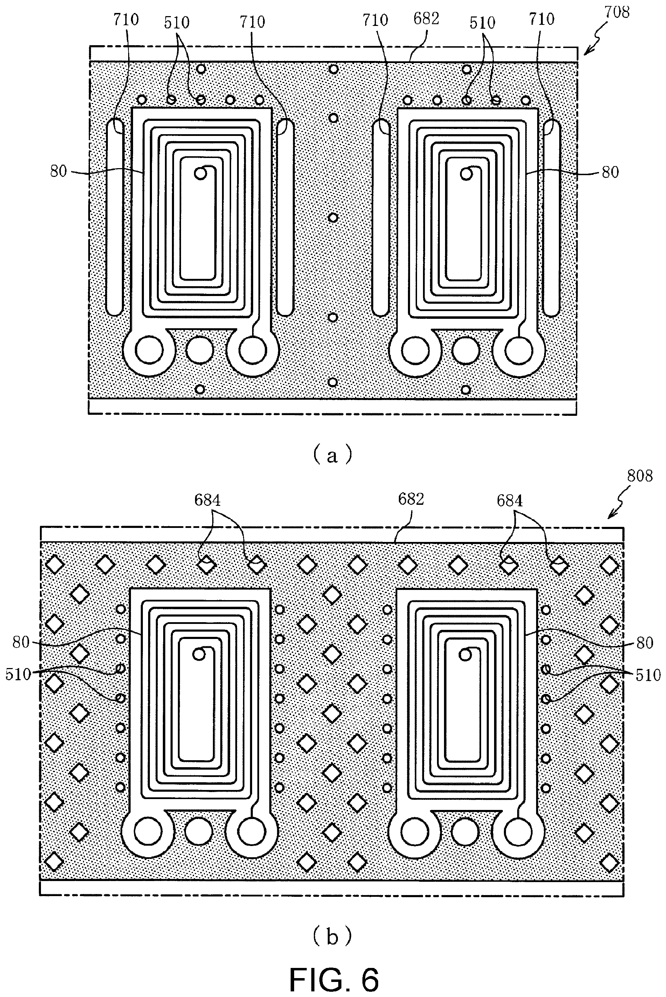

Next, the fifth to eighth embodiments will be described with reference to FIG. 5 and FIG. 6. In the first to fourth embodiments described above and the fifth to eighth embodiments described below, the same parts are denoted by the same reference numerals and the description thereof is omitted. (a) of FIG. 5 is a top view of the substrate 508 according to the fifth embodiment, and (b) of FIG. 5 is a top view of the substrate 608 according to the sixth embodiment. (a) of FIG. 6 is a top view of the substrate 708 according to the seventh embodiment, and (b) of FIG. 6 is a top view of the substrate 808 according to the eighth embodiment.

As shown in (a) of FIG. 5, the substrate 508 of the fifth embodiment is obtained by forming through holes 510 in the substrate 8 of the first embodiment. The through hole 510 is a through hole penetrating the front and rear of the substrate 508, and the inner wall of the through hole 510 is plated.

A plurality of through holes 510 are formed at four corners and each side (long side and short side) of the rectangular ring-shaped magnetic shield 82a (magnetic shield 82b, not shown). In this embodiment, all of the plurality of through holes 510 are arranged to divide the magnetic shield 82a (the magnetic shield 82a becomes intermittent), but not limited thereto. For example, some (or all) of the through holes 510 may be arranged to partially cut out the magnetic shield 82a.

Even with such through holes 510, magnetic interference between the adjacent coils 80 can be suppressed by the magnetic shield 82a (magnetic shield 82b, not shown).

As shown in (b) of FIG. 5, the substrate 608 of the sixth embodiment is obtained by forming the magnetic shield 682 that partitions the coils 80 with a solid ground (connected to the ground). Although not shown, the magnetic shield 682 is laminated on the front and rear outer layers of the substrate 608 in the same manner as the magnetic shields 82a and 82b of the first embodiment.

The magnetic shield 682 is formed with a plurality of blank portions (blanks) for providing a linear gap 683 between the magnetic shield 682 and each coil 80 arranged in the scale direction. A plurality of through holes 510 surrounding this gap 683 are formed in the substrate 608. Such a magnetic shield 682 is also capable of suppressing interference between the magnetic fields of adjacent coils 80.

The magnetic shield 682 is formed continuously in the scale direction except for the blank portion that forms the gap 683 with the coil 80 and the region where the through holes 510 are formed. That is to say, the coils 80 are partitioned by the magnetic shield 682 formed of one sheet of conductive pattern, but the magnetic shield 682 may be divided into multiple parts in the scale direction. Besides, the magnetic shield 682 may not be connected to the ground, or the through holes 510 may be omitted.

As shown in (a) of FIG. 6, the substrate 708 of the seventh embodiment is obtained by changing a plurality of through holes 510 arranged along the long side of the coil 80, among the through holes 510 of the substrate 608 (see (b) of FIG. 5) of the sixth embodiment, into elongated through holes 710.

A pair of through holes 710 are formed to sandwich each of the coils 80 arranged in the scale direction, and each through hole 710 extends in a direction orthogonal to the scale direction. Two through holes 710 are formed respectively between the coils 80 arranged in the scale direction, but one or three or more through holes 710 may be formed between the coils 80. Also, the two (multiple) through holes 710 formed between the coils 80 may be connected in the scale direction.

Further, for example, when the through hole 710 is a hole such as a via and an access hole (that does not penetrate the substrate 708), the hole may be formed in a continuous ring shape (rectangular ring shape) to surround the coil 80.

As shown in (b) of FIG. 6, the substrate 808 of the eighth embodiment is obtained by forming only the through holes 510 along the long side of the coil 80, among the through holes 510 (see (b) of FIG. 5) of the sixth embodiment (other through holes 510 are omitted), and forming a plurality of rectangular holes 684 in the magnetic shield 682. The plurality of holes 684 are distributed substantially uniformly over the region where the magnetic shield 682 is formed. That is, the magnetic shield 682 is a solid ground provided with so-called cross hatching.

By providing cross hatching on the magnetic shield 682, the porosity of the magnetic shield 682 is higher than in the sixth embodiment (see (b) of FIG. 5), which suppresses the magnetic field of the magnetic shield 682 from interfering with the magnetic field of each coil 80.

Although the present invention has been described based on the above embodiments, the present invention is by no means limited to the above embodiments, and it can be easily inferred that various modifications and improvements are possible without departing from the gist of the present invention.

Part or all of each of the above embodiments may be combined with or exchanged with part or all of other embodiments. Thus, for example, the magnetic shield 682 (solid ground) of the sixth to eighth embodiments may be formed on the outer peripheral side of the magnetic shields 82a and 82b of the first and fifth embodiments, or the magnetic shields 82a and 82b (divided by the through holes 510) of the fifth embodiment may be formed on the outer peripheral side of the magnetic shields 82a and 82b of the first embodiment.

Although the above embodiments illustrate a synthesizer as an example of the keyboard device 1, the present invention is not necessarily limited thereto. For example, if the keyboard device 1 is an electronic organ, the device may be configured to detect the displacement of a foot keyboard (operation member) operated by the player based on an increase or decrease in the inductance of the coil 80. If the keyboard device 1 is an electronic piano, the device may be configured to detect the displacement of three pedals (operation members) operated by the player based on an increase or decrease in the inductance of the coil 80. The configurations related to the magnetic shields 82a, 82b, and 682 of the above embodiments are applicable to any configuration.

Although the above embodiments illustrate a case where the displacement of the displacement member 7 interlocked with the key 2 (white key 2a) is detected based on an increase or decrease in the inductance of the coil 80, the present invention is not necessarily limited thereto. For example, the displacement member 7 may be omitted and the displacement of other displacement members such as a hammer (which is interlocked with the key 2 and gives a feeling of key depression) and the key 2 may be detected based on an increase or decrease in the inductance of the coil 80. In addition, for example, the displacement of the displacement member 7 interlocked with the hammer, the foot keyboard of the electronic organ, or the three pedals of the electronic piano may be detected based on an increase or decrease in the inductance of the coil 80. The configurations related to the magnetic shields 82a, 82b, and 682 of the above embodiments are also applicable to these configurations.

Although the above embodiments illustrate a case where the displacement member 7 rotates around the shaft portion 92, the displacement member 7 may be slidably displaced (the rotation of the operation member such as the key 2 is converted into linear motion), and the sliding displacement of the displacement member 7 may be detected based on an increase or decrease in the inductance of the coil 80.

In the above embodiments, description of the method for forming the detected portion 75 is omitted. For example, the detected portion 75 may be formed by attaching a metal plate to the outer surface of the displacement member 7, plating the surface of the displacement member 7, or the like.

Although the above embodiments illustrate a case where three layers of laminated plates 81a to 81c and four layers of laminated plates 481a to 481d are laminated (the substrate is a multilayer printed wiring board), the substrate may have a single layer, two layers, five layers, or more.

The above embodiments illustrate a configuration in which the substrate 8 is directly supported by the bottom plate 3. However, when the bottom plate 3 is a conductor such as a steel plate, for example, it is preferable to float the substrate 8 from the bottom plate 3 (for example, to support the substrate 8 on a synthetic resin chassis 4 so that the bottom plate 3 and the substrate 8 are not in contact with each other). As a result, the influence of the conductive bottom plate 3 on the magnetic field of the coil 80 can be suppressed. Similarly, when the chassis 4 is a conductor such as a steel plate, it is preferable to support the substrate 8 on the bottom plate 3 that is formed using a non-conductor such as synthetic resin and wood. Thereby, the influence of the conductive chassis 4 on the magnetic field of the coil 80 can be suppressed.

Although the first to fifth embodiments illustrate a case where the magnetic shields 82a and 82b are formed in a rectangular ring shape, the present invention is not necessarily limited thereto. For example, the portions extending in the scale direction of the rectangular ring-shaped magnetic shields 82a and 82b may be omitted, and each coil 80 may be partitioned by linear magnetic shields 82a and 82b that extend in a direction orthogonal to the scale direction. Also, the magnetic shields 82a and 82b may have curved or bent portions, or the magnetic shields 82a and 82b may be formed in an annular or other polygonal shape. That is, the shapes of the magnetic shields 82a and 82b can be appropriately set and do not necessarily correspond to the shape of the coil 80 as long as the magnetic shields 82a and 82b can partition the coils 80 arranged in the scale direction (for example, a circular coil 80 may be surrounded by rectangular ring-shaped magnetic shields 82a and 82b).

When the magnetic shields 82a and 82b are formed in a ring shape, preferably the width dimension of the magnetic shields 82a and 82b is substantially constant over the entire periphery. A substantially constant width dimension means that the minimum and maximum values of the width dimension are within a range of ±30% of the average value of the width dimension over the entire periphery of the magnetic shields 82a and 82b.

By setting the width dimension of the magnetic shields 82a and 82b constant over the entire periphery, interference of the magnetic fields from the magnetic shields 82a and 82b is received uniformly over the entire periphery of the coil 80.

However, the width dimension of the magnetic shields 82a and 82b may change in some or all regions in the circumferential direction of the magnetic shields 82a and 82b (for example, the width dimension of a portion of the magnetic shields 82a and 82b is narrower or thicker than other portions).

Although the first to fifth embodiments illustrate a case where the magnetic shields 82a and 82b arranged in the scale direction have the same shape (rectangular ring shape), the present invention is not necessarily limited thereto. For example, magnetic shields having different shapes such as a rectangular ring shape and a circular ring shape may be combined to partition each coil 80.

Although the first to fifth embodiments illustrate a case where the magnetic shields 82a and 82b are laminated in the same layer as one of the coils 80a to 80d, the present invention is not necessarily limited thereto. For example, the magnetic shields 82a and 82b may be laminated in a layer different from the coils 80a to 80d.

Although the first to fifth embodiments illustrate a case where the magnetic shields 82a and 82b are not connected to the circuit that constitutes the substrate such as the ground (a portion (layer) that serves as a reference potential for operating the electronic circuit of the substrate) and the adjacent magnetic shields 82a and 82b are not connected to each other, the present invention is not necessarily limited thereto. For example, the magnetic shields 82a and 82b may be connected to the ground, or part or all of the magnetic shields 82a and 82b arranged in the scale direction may be connected by a conductor (copper foil).

Although the first to fifth embodiments illustrate a case where a plurality of (four layers or two layers) of coils 80a to 80d and magnetic shields 82a and 82b are laminated, the present invention is not necessarily limited thereto. For example, one or both of the coils 80a and 80d and the magnetic shields 82a and 82b may be a single layer. Also, the numbers of layers of the coils and the magnetic shields may be the same, or the magnetic shield may be laminated in more layers than the coil.

Although the fifth to eighth embodiments illustrate a case where the through holes 510 and 710 are formed in the substrate, other holes such as plain holes, vias, access holes, component holes, and reference holes may be formed at positions overlapping the magnetic shields 82a, 82b, and 682, besides the through holes 510 and 710 (or instead of the through holes 510 and 710). Further, these other holes or through holes 510 and 710 may be formed in the region between the coils 80 and the magnetic shields 82a, 82b, and 682. Among these holes, holes with the inner wall plated can be manufactured by a known method, so a detailed description thereof will be omitted. The known method includes, for example, forming a hole in the laminated plate with a cutting tool such as a drill and plating both surfaces of the laminated plate, which includes the inner peripheral surface of the hole, to form a copper foil.

### Reference Signs List

1 keyboard device
7 displacement member
8, 208, 308, 408, 508, 608, 708, 808 substrate
80, 80a to 80d coil
81 a to 81 c, 481a to 481d laminated plate
82a magnetic shield (first magnetic shield)
82b magnetic shield (second magnetic shield)
682 magnetic shield
510, 710 through hole (hole)

## Claims

1. A keyboard device, **characterized in** comprising a plurality of displacement members arranged in a scale direction and displaced according to an operation of a player; and a substrate having a coil which generates a magnetic field for detecting displacement of the plurality of displacement members, wherein
the substrate comprises a plurality of the coils provided respectively for the plurality of displacement members, and a magnetic shield partitioning the plurality of coils and formed by a conductive pattern of the substrate.

2. The keyboard device according to claim 1, **characterized in that** a plurality of the magnetic shields are arranged in the scale direction, and the magnetic shield has a ring shape and surrounds an entire periphery of the coil.

3. The keyboard device according to claim 2, **characterized in that** the plurality of magnetic shields are not connected to a circuit that constitutes the substrate.

4. The keyboard device according to claim 2, **characterized in that** no hole is formed in the substrate at a position where the magnetic shield is formed.

5. The keyboard device according to claim 1, **characterized in that** the substrate is a multilayer substrate in which a plurality of laminated plates are laminated, and
a plurality of the coils and the magnetic shields are laminated together with the laminated plates.

6. The keyboard device according to claim 5, **characterized in that** the number of laminations of the magnetic shields is smaller than the number of laminations of the coils.

7. The keyboard device according to claim 1, **characterized in that** the magnetic shields comprise a first magnetic shield and a second magnetic shield laminated in a lower layer than the first magnetic shield,
a plurality of the first magnetic shields arranged in the scale direction are laminated in the same layer, and
a plurality of the second magnetic shields arranged in the scale direction are laminated in the same layer.

8. The keyboard device according to claim 1, **characterized in that** the magnetic shields comprise a first magnetic shield and a second magnetic shield laminated in a lower layer than the first magnetic shield,
the first magnetic shields adjacent in the scale direction are laminated in different layers, and
the second magnetic shields adjacent in the scale direction are laminated in different layers.

9. A magnetic shield forming method for forming a magnetic shield in a keyboard device, which comprises a plurality of displacement members arranged in a scale direction and displaced according to an operation of a player, and a substrate having a coil which generates a magnetic field for detecting displacement of the plurality of displacement members, wherein the substrate comprises a plurality of the coils provided respectively for the plurality of displacement members, and the magnetic shield partitioning the plurality of coils, the magnetic shield forming method **characterized in** comprising:
forming the magnetic shield by a conductive pattern of the substrate.
